# EUROPEAN PATENT APPLICATION

(11) **EP 4 468 373 A1**
(43) Date of publication of application: **27.11.2024**
(21) Application number: 23203415.7
(22) Date of filing: 13.10.2023
(51) Int. Cl.: H01L 31/0224, H01L 31/042, H01L 31/05, H01L 31/18

(54) **SOLAR CELL, PHOTOVOLTAIC MODULE, AND METHOD FOR MANUFACTURING A SILICON SUBSTRATE**

(30) Priority: 23.05.2023 CN 202310588789; 23.05.2023 CN 202310588708
(71) Applicant: Zhejiang Jinko Solar Co., Ltd., Haining, Zhejiang 314416 (CN); JINKO SOLAR CO., LTD, ShangRao, Jiangxi 334100 (CN)
(72) Inventor: Tao, Wusong, Haining, 314416 (CN); Li, Tingting, Haining, 314416 (CN); Xu, Tao, Haining, 314416 (CN)
(74) Representative: Müller Schupfner & Partner Patent- und Rechtsanwaltspartnerschaft mbB (Muc)

(57) **Abstract**

Provided are a solar cell, a photovoltaic module, and a method for manufacturing a silicon wafer. The solar cell includes a silicon substrate in a rectangular shape, and 13 to 20 busbars. The busbars are sequentially arranged along a width direction of the solar cell at an equal spacing of *a* mm. The silicon substrate includes a first edge and a second edge opposite to the first edge in the width direction of the solar cell. A distance between the first edge of the silicon substrate and an outermost busbar adjacent to the first edge is *b* mm, where *a*-1≤2*b*≤*a*+1.

## Description

### TECHNICAL FIELD

The present disclosure relates to the photovoltaic field, and in particular, to a solar cell, a photovoltaic module, and a method for manufacturing a silicon substrate.

### BACKGROUND

With the development of technologies, photovoltaic devices are more and more widely used. A solar cell of the photovoltaic device is configured to convert light energy into electrical energy. The solar cell includes busbars. The busbars are configured to collect currents generated by the solar cell. In general, the busbars are arranged spaced apart along a width direction of the solar cell. The current generated in a region at an edge of the solar cell can only be collected by the outermost busbar, and the currents generated in a region between adjacent busbars can be collected by both the two adjacent busbars. As a result, currents generated in different regions of the solar cell are transported by different distances, reducing efficiency.

### SUMMARY

Embodiments of the present disclosure provide a solar cell, a photovoltaic module, and a method for manufacturing a silicon substrate. The solar cell and the photovoltaic module have an improved efficiency in current collection.

According to one aspect of the present disclosure, a solar cell is provided. The solar cell includes: a silicon substrate in a rectangular shape, and a plurality of busbars.

The plurality of busbars are arranged on the silicon substrate, and a number of the busbars ranges from 13 to 20.

The plurality of busbars extend along a length direction of the solar cell, and are sequentially arranged along a width direction of the solar cell at an equal spacing of *a* mm. The silicon substrate includes a first edge and a second edge opposite to the first edge in the width direction of the solar cell. A distance between the first edge of the silicon substrate and an outermost busbar of the busbars (2) adjacent to the first edge is *b* mm, where *a*-1≤2*b*≤*a*+1*.*

In some embodiments, the spacing between adjacent busbars is twice of the distance.

In some embodiments, the distance satisfies: 5 mm≤*b*≤10 mm.

In some embodiments, the spacing between adjacent busbars satisfies: 10 mm≤*a*≤20 mm.

In some embodiments, a width of the solar cell ranges from 182 mm to 210 mm, and a length of the solar cell ranges from 180 mm to 220 mm.

In some embodiments, the solar cell includes two half-cut solar cells, and the two half-cut solar cells are symmetrical about a center line of the solar cell extending along the width direction of the solar cell.

In some embodiments, the number of the busbars ranges from 13 to 16.

In some embodiments, the silicon substrate has a chamfered arc, and the chamfered arc has an arc length ranging from 0.5 mm to 6 mm.

In some embodiments, the silicon substrate has a chamfered arc, and the chamfered arc has a central angle ranging from 0.3° to 3°.

According to another aspect of the present disclosure, a photovoltaic module is provided. The photovoltaic module includes: a first cover plate, a first sealant, a solar cell layer, a second sealant, and a second cover plate sequentially arranged along a thickness direction.

The solar cell layer includes a solar cell array having a plurality of solar cells, and each solar cell is configured to be processed into half-cut solar cells. At least one of the plurality of solar cells is the solar cell according to any one of the above.

In some embodiments, a width of the photovoltaic module ranges from 1130 mm to 1138 mm, and a length of the photovoltaic module ranges from 2380 mm to 2384 mm.

In some embodiments, 4 to 6 solar cells are arranged along a width direction of the photovoltaic module, and 8 to 14 solar cells are arranged along a length direction of the photovoltaic module.

According to yet another aspect of the present disclosure, a method for manufacturing a silicon substrate in the solar cell according to any one of the above is provided. The method includes the following steps:
providing a silicon ingot, which is a cylinder with a cross-section diameter ranging from 252 mm to 277 mm;
selecting four arc segments on a circumference of the silicon ingot according to chamfer parameters of the silicon substrate;
cutting the silicon ingot along connection lines between adjacent arc segments to obtain a rectangular body having a rectangular cross-section shape with chamfers; and
cutting the rectangular body along a direction perpendicular to a length direction of the silicon ingot and obtaining a rectangular silicon wafer with chamfers.

In some embodiments, the step of selecting four arc segments on a circumference of the silicon ingot according to chamfer parameters of the silicon substrate includes: selecting four arc segments each with a arc length ranging from 0.5 mm to 6 mm on the circumference of the silicon ingot, where circle centers of the four arc segments coincide with a center of a cross section of the silicon ingot.

In some embodiments, the step of selecting four arc segments on a circumference of the silicon ingot according to chamfer parameters of the silicon substrate includes: selecting four arc segments each with a central angle ranging from 0.3° to 3° on the circumference of the silicon ingot, where circle centers of the four arc segments coincide with a center of a cross section of the silicon ingot.

In some embodiments, the step of cutting the rectangular body along a direction perpendicular to a length direction of the silicon ingot and obtaining a rectangular silicon wafer with chamfers includes: obtaining the rectangular silicon wafer with a width ranging from 182 mm to 188 mm by cutting the rectangular body.

In some embodiments, the step of cutting the rectangular body along a direction perpendicular to a length direction of the silicon ingot and obtaining a rectangular silicon wafer with chamfers includes: obtaining the rectangular silicon wafer with a length ranging from 180 mm to 220 mm by cutting the rectangular body.

In some embodiments, after obtaining the rectangular silicon wafer with chamfers, the method further includes: cutting, along a straight line parallel to a width direction of the rectangular silicon wafer, the rectangular silicon wafer into two symmetrical half-cut wafers.

The present disclosure relates to a solar cell, a photovoltaic module, and a method for manufacturing a silicon substrate. The solar cell includes a silicon substrate in a rectangular shape, and 13 to 20 busbars. The busbars are sequentially arranged along a width direction of the solar cell at an equal spacing of *a* mm. The silicon substrate includes a first edge and a second edge opposite to the first edge in the width direction of the solar cell, and a distance between the first edge of the silicon substrate and an outermost busbar of the busbars adjacent to the first edge is *b* mm, where *a*-1≤2*b*≤*a*+1*.* This design is conducive to reducing a transport distance of a current at the edge of the silicon substrate, thereby helping to improve efficiency of the solar cell.

It should be understood that the general description above and the detailed description in the following are merely exemplary and illustrative, and cannot limit the present disclosure.

### BRIEF DESCRIPTION OF DRAWINGS

FIG. 1 is a schematic diagram of a solar cell according to some embodiments of the present disclosure;
FIG. 2 is a schematic diagram of a conventional solar cell;
FIG. 3 is a schematic diagram of a cutting position of the solar cell according to some embodiments of the present disclosure;
FIG. 4 is a schematic diagram of a photovoltaic module according to some embodiments of the present disclosure;
FIG. 5 is a partial schematic diagram of the solar cell according to some embodiments of the present disclosure;
FIG. 6 is a flowchart of a method for manufacturing a silicon substrate according to the present disclosure;
FIG. 7 is a schematic diagram of cutting positions of a silicon ingot according to the present disclosure;
FIG. 8 is a schematic diagram of a silicon substrate according to the present disclosure;
FIG. 9 is a flowchart of selecting four arc segments on a circumference of a silicon ingot according to chamfer parameters of the solar cell according to the present disclosure;
FIG. 10 is a flowchart of cutting a rectangular body having a rectangular cross-section shape with chamfers along a direction perpendicular to a length direction of the silicon ingot to obtain a rectangular silicon substrate with chamfers according to the present disclosure;
FIG. 11 is a schematic diagram of cutting positions of the silicon ingot according to the present disclosure;
FIG. 12 is a schematic diagram of dividing a mother solar cell into two half-cut solar cells; and
FIG. 13 is a schematic diagram of a solar cell layer in a photovoltaic module.

### Reference signs:

1': substrate; 2': busbar; 8': pad;
1: silicon substrate;
2: busbar;
3: first cover plate;
4: first sealant;
5: solar cell layer;
   51: solar cell;
6: second sealant;
7: second cover plate;
8: pad;
9: silicon ingot.

The accompanying drawings herein are incorporated in and constitute a part of this specification, illustrate embodiments consistent with the present disclosure and, together with the specification, serve to explain the principles of the present disclosure.

### DESCRIPTION OF EMBODIMENTS

In order to better understand the technical solution of the present disclosure, embodiments of the present disclosure are described in detail below with reference to the accompanying drawings.

It is to be made clear that the described embodiments are only some rather than all of the embodiments of the present disclosure. All other embodiments obtained by those of ordinary skill in the art based on the embodiments in the present disclosure without creative efforts fall within the protection scope of the present disclosure.

The terms used in the embodiments of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means an "or" relationship between the associated objects.

It is to be noted that the location terms such as "above", "below", "left", and "right" described in the embodiments of the present disclosure are described with reference to the angles shown in the accompanying drawings, and should not be construed as limitations on the embodiments of the present disclosure. In addition, in the context, it is to be further understood that, when one element is referred to as being connected "above" or "below" another element, the one element may be directly connected "above" or "below" another element, or connected "above" or "below" another element via an intermediate element.

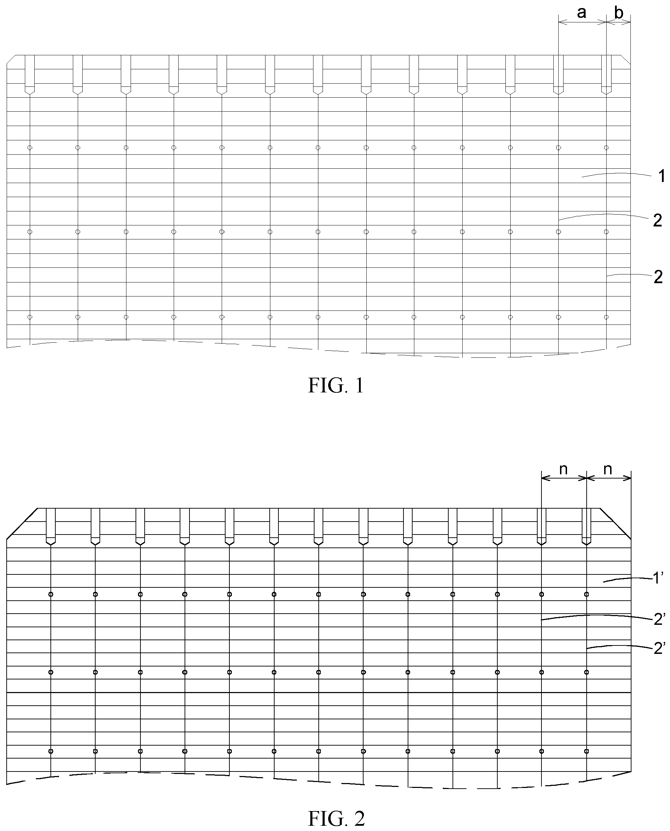

As shown in FIG. 1, some embodiments of the present disclosure provide a solar cell 51. The solar cell 51 includes a substrate 1. An example substrate 1 is a silicon substrate. The substrate 1 is in a rectangular shape. The solar cell 51 further includes a plurality of busbars 2 on a surface of the solar cell 51. The busbars 2 are configured to collect currents from fingers electrodes. The finger electrodes extract photo-generated current from the substrate 1. The busbars 2 are sequentially arranged along a width direction of the solar cell 51 and extend along a length direction of the solar cell 51. A number of the busbars 2 ranges from 13 to 20. The busbars 2 are arranged at an equal spacing. This means, the distance between any adjacent busbars 2 is equal. The spacing/distance between adjacent busbars 2 is equal to *a* mm. The silicon substrate 1 includes a first edge and a second edge opposite to the first edge in the width direction of the solar cell 51, and a distance between the first edge of the silicon substrate 1 and an outermost busbar 2 adjacent to the first edge is b mm. The outermost busbar 2 adjacent to the first edge is one of the busbars 2 closest to the first edge. The spacing and the distance satisfy: *a*-1≤2*b*≤*a*+1*.*

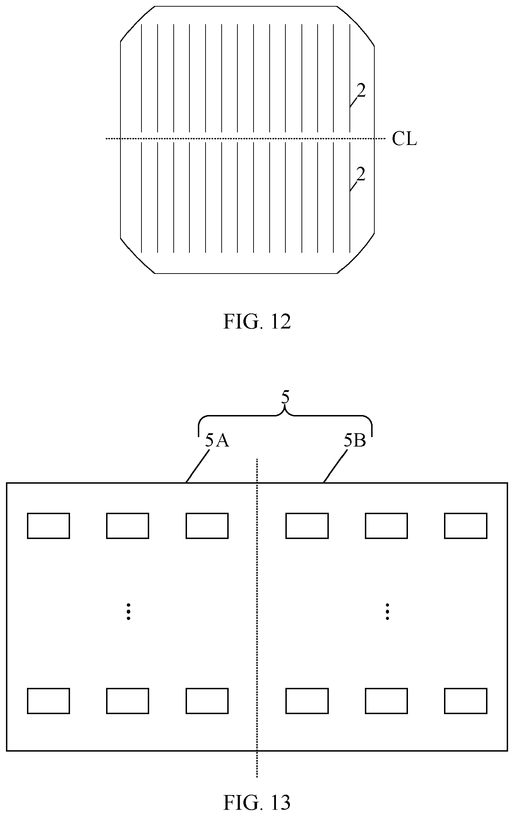

The solar cell 51 may be a mother solar cell, and the mother solar cell may be divided into two or more fragments. For example, as shown in FIG. 12, the mother solar cell is divided into two half-cut solar cells by cutting along the line CL. Each half-cut solar cell may include 13 to 20 busbars 2. The number of the busbars 2 may be 13, 14, 15, 16, 17, 18, 19, or 20.

As shown in FIG. 2, in a conventional solar cell, busbars 2' are evenly arranged on a substrate 1', the distance between the outermost busbar 2' and the edge of the substrate 1' is equal to the distance between adjacent busbars 2'. For example, the distance between the adjacent busbars 2' is n mm, and the distance between the outermost busbar 2' and its adjacent edge of the substrate 1' is also n mm. Current generated in a region between adjacent busbars 2' can be collected by both the adjacent busbars 2', and the current may flow to the closer busbar 2'. However, current generated in the region in the edge region of the substrate can only be collected by the outermost busbar 2'. That is, the non-outermost busbar 2' collects currents from a range having a width approximately 0.5n mm on two sides of the non-outermost busbar 2', and a total collection range of a single non-outermost busbar 2' is approximately n mm. For the outermost busbars 2', a collection range on one side adjacent to another busbars 2' is approximately 0.5n mm, and a collection range on one side adjacent to the edge of the substrate 1' is n mm. That is, a total collection range of the outermost busbars 2' is 1.5n mm. As a result, the collection range of the outermost busbar 2' and the collection range of the non-outermost busbar 2' are different in sizes. Moreover, a transport distance of the current in the edge region of the substrate 1' is longer than a transport distance of the current in the middle region of the substrate 1', which leads to lower transfer of the current in the edge region. During an electroluminescence (EL) test, black edging may occur at the edge position.

In the solar cell provided in embodiments of the present disclosure, positions of the busbars 2 are adjusted, and the distance *a* between adjacent busbars 2 and the distance *b* between the outermost busbar 2 and the edge of the substrate 1 adjacent thereto satisfy: *a*-1≤2*b*≤*a*+1*.* Compared with the conventional solar cell, a difference between a transport distance of the current in the edge region of the substrate 1 and a transport distance of the current in a region in the middle region is reduced. As a result, collection ranges of the busbars 2 are nearly the same, and the transport distance of the current in the edge region is reduced, thereby helping to improve overall transmission efficiency.

A redundancy range of ±1 mm can reduce the requirement for manufacturing accuracy, thereby reducing manufacturing difficulty and improving manufacturing efficiency.

When the number of the busbars 2 is excessively small, each busbar 2 is responsible for a larger collection region, which is likely to affect transfer efficiency of the current. When the number of the busbars 2 is excessively large, the area of the substrate 1 shielded by the busbars 2 increases, which affects a light-receiving area of the substrate 1, thereby affecting light absorption efficiency of the substrate 1, reducing photoelectric conversion efficiency of the solar cell 511, and resulting in a decrease in overall efficiency of the solar cell 51 and the photovoltaic module. Therefore, there is a need to select a suitable number of busbars 2 according to an actual requirement, so that the solar cell 51 and the photovoltaic module can have higher efficiency.

In some embodiments, the distance *a* between adjacent busbars 2 and the distance b between the outermost busbar 2 and the edge of the substrate 1 adjacent thereto satisfy: 2*b*=*a.*

Through this design, collection ranges of the busbars 2 can be the same. As a result, a transport distance in the edge region of the substrate 1 is reduced, the transfer efficiency of the current can be further improved, and transport distances of the currents generated at various positions of the solar cell 51 are relatively uniform, thereby improving efficiency of the solar cell 51.

In some embodiments, the distance *b* between the outermost busbar 2 and the edge of the substrate 1 adjacent thereto satisfies: 5 mm≤*b*≤10 mm. The distance *b* between the outermost busbar 2 and the edge of the substrate 1 adjacent thereto may be 5 mm, 6 mm, 7 mm, 8 mm, 9 mm, 10 mm, or the like.

In some embodiments, the distance *a* between adjacent busbars 2 satisfies: 10 mm≤*a*≤20 mm. The distance *a* between adjacent busbars 2 may be 10 mm, 11 mm, 12 mm, 13 mm, 14 mm, 15 mm, 16 mm, 17 mm, 18 mm, 19 mm, 20 mm, or the like.

The distance *a* between adjacent busbars 2 and the distance b between the outermost busbar 2 and the edge of the substrate 1 adjacent thereto may be selected according to an actual situation. For example, the distance *a* between adjacent busbars 2 and the distance b between the outermost busbar 2 and the edge of the substrate 1 adjacent thereto may be selected based on a size of the substrate 1, the number of the busbars 2, and the like.

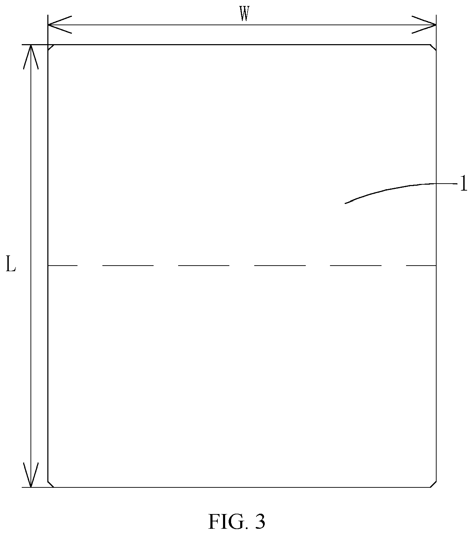

As shown in FIG. 3, in some embodiments, a width W of the solar cell 51 ranges from 182 mm to 210 mm, and a length L of the solar cell 51 ranges from 180 mm to 220 mm.

The width of the solar cell 51 may be 182 mm, 184 mm, 186 mm, 188 mm, 190 mm, 192 mm, 194 mm, 196 mm, 198 mm, 200 mm, 202 mm, 204 mm, 206 mm, 208 mm, 210 mm, or the like. The length of the solar cell 51 may be 180 mm, 182 mm, 184 mm, 186 mm, 188 mm, 190 mm, 192 mm, 194 mm, 196 mm, 198 mm, 200 mm, 202 mm, 204 mm, 206 mm, 208 mm, 210 mm, 212 mm, 214 mm, 216 mm, 218 mm, 220 mm, or the like.

Compared with a square solar cell 51, a rectangular solar cell 51 has a larger area, and thus can receive more light, thereby having higher photoelectric conversion efficiency. Moreover, the solar cell 51 provided in some embodiments of the present disclosure is more convenient to transport after assembled, which improves utilization of a container, thereby improving efficiency of transportation.

In some embodiments, the solar cell 51 provided in some embodiments of the present disclosure is a mother solar cell. The mother solar cell is produced in a standard size. The solar cell 51 includes two half-cut solar cells, and the two half-cut solar cells are symmetrical about a center line of the solar cell 51 extending in the width direction of the solar cell 51. That is, the solar cell 51 is divided into two symmetrical half-cut solar cells by cutting the solar cell 51 along the width direction through a center point of the solar cell 51. In some embodiments, the solar cell 51 may be cut along dotted lines shown in FIG. 3.

In use, the solar cells 51 may each be cut into half-cut solar cells, and then the half-cut solar cells are arranged in an array, assembled, and electrically connected. Compared with arranging the mother solar cells 51 into an array, the use of the half-cut solar cells in the photovoltaic module improves efficiency of the photovoltaic module and is more in line with an actual use requirement. A cutting direction is perpendicular to an extension direction of the busbar. Therefore, after the cutting, each half-cut solar cell includes 13 to 20 busbars.

In some embodiments, the number of the busbars 2 may range from 13 to 16. Compared with a conventional solar cell 51, the number of the busbars 2 may be reduced appropriately. If the size of the substrate 1 is constant, since the number of the busbars 2 decreases, the distance between adjacent busbars 2 may increase, thereby expanding the collection range of the busbar 2 in the middle region. As a result, an overall current transport distance is balanced, the number of the busbars 2 is reduced, the area of the substrate 1 shielded by the busbars 2 is also reduced, the overall photoelectric conversion efficiency is improved, and at the same time, the required solder strips and an amount of silver paste required accordingly during soldering are also reduced. Therefore, in consideration of factors such as the area of the substrate 1 shielded by the busbar 2 and the manufacturing cost, the distance between adjacent busbars 2 can be adjusted by reducing the number of the busbars 2 in the middle region. In this way, the distance between adjacent busbars 2 is equal to the distance from the outermost busbar 2 to the edge of the substrate 1 adjacent thereto, and transport distances of the currents at various positions of the substrate 1 substantially are the same, which improves efficiency of the solar cell 51 and reducing the cost, and is more in line with an actual manufacturing requirement.

The solar cell in a conventional photovoltaic module is in a square shape, while the solar cell 51 provided in some embodiments of the present disclosure is in a rectangle shape. A dimension of the solar cell 51 along the length direction increases, and the length of the busbar 2 may also increase. Therefore, when a number of pads 8 is not increased, in order to improve connection stability of the busbar 2, positions of the pads 8 may generally be adjusted to increase the distance between adjacent pads 8, so that the pads 8 can be relatively evenly distributed along an extension direction of the busbar 2, thereby reducing an influence of the length-increased busbar 2 on the connection stability.

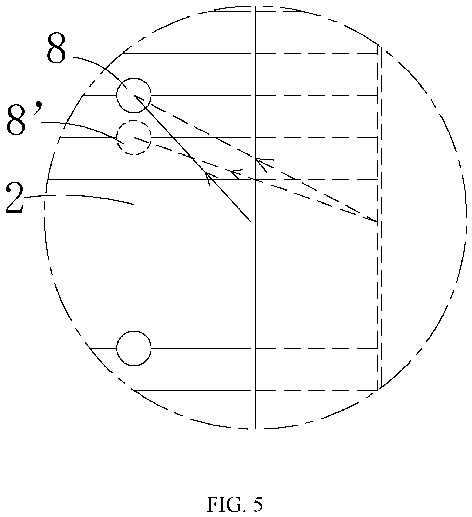

As shown in FIG. 5, the dotted line represents the boundary/edge of the square solar cell, and the solid line represents the boundary/edge of the rectangular solar cell 51 provided in some embodiments of the present disclosure. The dotted pad 8' represents a position of a pad 8' of the square solar cell, and a solid pad 8 represents a position of a pad 8 of the rectangular solar cell 51 provided in some embodiments of the present disclosure.

The current may preferentially flow to the nearest pad 8. Compared with the square solar cell, due to an increase in the distance between adjacent pads 8 of the rectangular solar cell 51, the transport distance of the current at the edge region may also increase, resulting in a further decrease in the current transport efficiency in the edge region, and affecting efficiency of the solar cell 51. Therefore, in embodiments of the present disclosure, a distance between an edge of the solar cell 51 and the outermost busbar 2 adjacent thereto is reduced by adjusting the position of the busbar 2. As a result, the transport distance of the current is reduced, and thus, transport distances of currents at various positions of the solar cell 51 are nearly the same, thereby improving overall efficiency of the solar cell 51.

In view of the above, compared with the conventional square solar cell in which the distances between adjacent busbars 2' and the distance from the outermost busbar 2' to the edge of the solar cell 51 are equal, in the rectangular solar cell 51 provided in embodiments of the present disclosure, the distance between outermost busbar 2 and the edge of the solar cell 51 adjacent thereto can be reduced by adjusting the position of the busbar 2, so that the current transport distance in the edge region of the solar cell 51 is shortened, which improves the efficiency of the solar cell 51. Moreover, compared with the square solar cell, the rectangular solar cell 51 has a larger area and receives more light, which further improves the efficiency of the solar cell 51.

Arrow lines in FIG. 5 indicate general transport directions of currents, which do not represent actual transport paths.

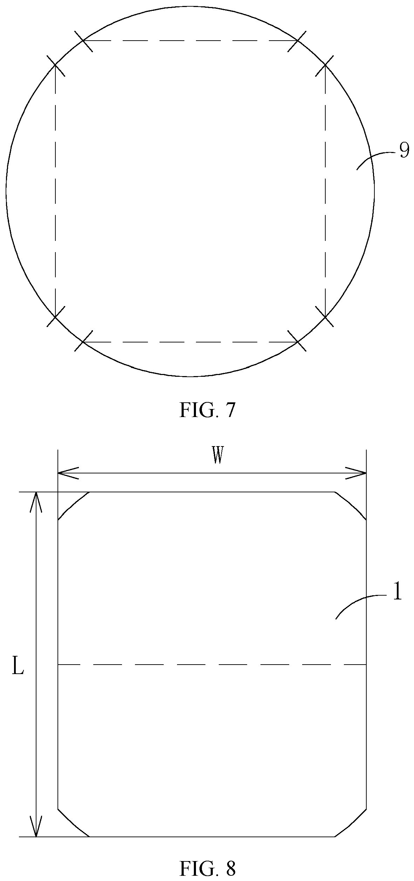

In some embodiments, the silicon substrate 1 has a chamfered arc. As shown in FIG. 7, the silicon substrate 1 has chamfered corners, and each corner of the silicon substrate 1 is rounded and includes an arc edge, for example a circular arc edge. An arc length of the chamfered arc ranges from 0.5 mm to 6 mm, and/or a central angle of the chamfered arc ranges from 0.3° to 3°.

A circle center of the chamfered arc may coincide with a circle center of a silicon ingot 9 for manufacturing the silicon substrate 1. The arc length of the chamfered arc may be 0.5 mm, 1 mm, 1.5 mm, 2 mm, 2.5 mm, 3 mm, 3.5 mm, 4 mm, 4.5 mm, 5 mm, 5.5 mm, 6 mm, or the like. The central angle of the chamfered arc may be 0.3°, 0.6°, 0.9°, 1.2°, 1.5°, 1.8°, 2.1°, 2.4°, 2.7°, 3°, or the like.

A silicon substrate 1 with right-angle corners is prone to stress concentration in use, resulting in fragmentation. The silicon substrate 1 having chamfered corners with arc edges can reduce a fragmentation possibility of the silicon substrate 1, which improves the quality of the silicon substrate 1.

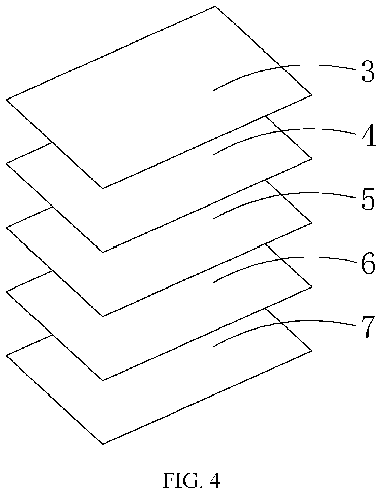

As shown in FIG. 4, based on the solar cells in the above embodiments, embodiments of the present disclosure further provide a photovoltaic module. The photovoltaic module includes: a first cover plate 3, a first sealant 4, a solar cell layer 5, a second sealant 6, and a second cover plate 7 that are sequentially arranged along a thickness direction. The first cover plate 3 may be a glass cover plate, and the second cover plate 7 may be a glass cover plate or a back sheet made of a light transmitting material, a non-light transmitting material or a reflective material and the like. The solar cell layer 5 includes a solar cell array. The solar cell array includes a plurality of solar cells 51. The solar cell layer 5 of the photovoltaic module may include half-cut solar cells formed by dividing the solar cell 51, or one-third-cut solar cells formed by dividing the solar cell 51. The half-cut solar cells or one-third-cut solar cells are arranged to form the solar cell array. For example, as shown in FIG. 13, the solar cells 51 are divided into half-cut solar cells, and the solar cell array of the solar cell layer 5 includes two sub-arrays 5A and 5B. That is, the solar cell layer 5 includes two regions. Each of the two sub-arrays 5A and 5B includes multiple half-cut solar cells. In some embodiments, the number of the half-cut solar cells in the sub-array 5A is equal to the number of the half-cut solar cells in the sub-array 5B. For example, the number of the half-cut solar cells in each sub-array is equal to the number of the solar cells 51. In some embodiments, the multiple half-cut solar cells in each sub-array are connected in series to form a string, and the two strings in the two sub-arrays are connected in parallel. The solar cell 51 may be the solar cell 51 in any one of the above embodiments. Since the solar cell 51 has the above technical effect, the photovoltaic module including the solar cell 51 also have the corresponding technical effect. Details are not described herein again.

In some embodiments, the second cover plate 7 is the glass cover plate, the photovoltaic module has a double-glass-cover-plate structure. That is, two opposite sides of the photovoltaic module can absorb light for photoelectric conversion. In some embodiments, the second cover plate 7 is the back sheet, the photovoltaic module has a single-glass-cover-plate structure. That is, one side of the photovoltaic module provided with the glass cover plate is used to receive light. The back sheet may have a reflective structure or be made of a material with reflection capability. The back sheet reflects light that is not absorbed by the solar cell 51, so as to improve utilization of the light and improve efficiency of the photovoltaic module.

In some embodiment, the solar cell array includes 4 to 6 solar cells 51 along a width direction of the photovoltaic module, and includes 8 to 14 solar cells 51 along a length direction of the photovoltaic module.

Through this design, the solar cells 51 can form a solar cell array so as to absorb light and convert the light into electrical energy. The solar cell array may include 4, 5, or 6 solar cells 51 along the width direction of the photovoltaic module. The solar cell array may include 8, 9, 10, 11, 12, 13, or 14 solar cells 51 along the length direction of the photovoltaic module. Generally, the solar cells 51 are divided into half-cut solar cells, and the half-cut solar cells are connected into one or more solar cell strings. The solar cell 51 may be referred to as a full cell or a mother cell. The half-cut solar cells in a same solar cell string are sequentially arranged along the length direction of the photovoltaic module. The solar cell array includes a plurality of solar cell strings sequentially arranged along the width direction of the photovoltaic module. That is, the solar cell array includes 4 to 6 solar cell strings. Each solar cell string may include 16 to 28 half-cut solar cells.

In some embodiments, the solar cell 51 in the photovoltaic module is divided into half-cut solar cells. The half-cut solar cells are formed by cutting the solar cell 51. The solar cell 51 may be equally divided along a line perpendicular to a length direction of the solar cell 51 to obtain two half-cut solar cells. The half-cut solar cells are symmetrical about a center line of the solar cell 51 along the width direction.

Compared with the structure of the full solar cell 51, the photovoltaic module using half-cut solar cells has higher efficiency.

In some embodiments, the solar cell array may include 6 solar cell strings, and each solar cell string may include 11 or 12 solar cells 51. That is, the solar cell array includes 66 solar cells 51 (132 half-cut solar cells) or 72 solar cells 51 (144 half-cut solar cells).

In some embodiments, a width of the photovoltaic module ranges from 1130 mm to 1138 mm, and a length of the photovoltaic module ranges from 2380 mm to 2384 mm.

Through this design, it is convenient to transport the photovoltaic module, utilization of a container space can be improved during the transportation, and an idle space of the container can be reduced, which is more in line with an actual use requirement.

In some embodiments, one solar cell 51 may also be equally divided into three or more sub-cell, and the sub-cell are arranged in array and assembled to form the photovoltaic module. An actual division manner of the solar cell 51 may be selected according to an actual requirement. Layout of the solar cell 51 in the solar cell array can be changed by adjusting the division manner of the solar cell 51, thereby adjusting a size of the photovoltaic module, so that the photovoltaic module is applicable to different scenarios and is more in line with an actual use requirement.

Some embodiments of the present disclosure further provide a method for manufacturing the solar cell 51 in the above embodiments.

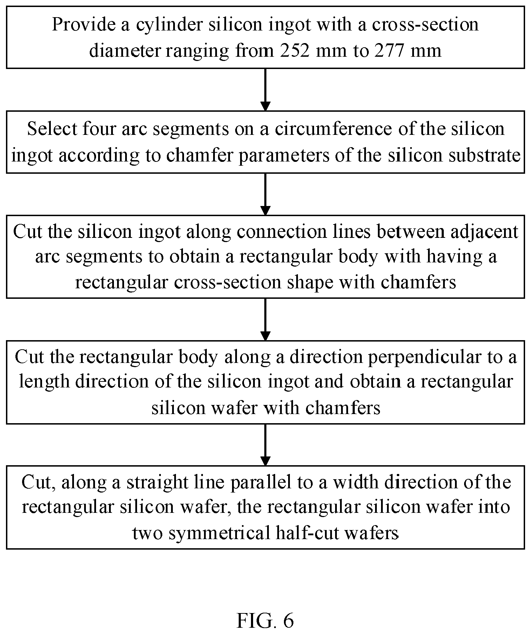

Some embodiments of the present disclosure further provide a method for manufacturing the photovoltaic module, which may be used for cutting a cylindrical silicon ingot 9 with a cross-section diameter ranging from 252 mm to 277 mm. As shown in FIG. 6, FIG. 7, and FIG. 8, the method may include the following steps.

In step S1, four arc segments are selected on a circumference of the silicon ingot 9 according to chamfer parameters of the solar cell 51.

In S2, the silicon ingot 9 is cut along connection lines between adjacent arc segments to obtain a rectangular body with chamfers.

In S3, the rectangular body with chamfers is cut along a direction perpendicular to a length direction of the silicon ingot 9 to obtain a rectangular silicon wafer 1 with chamfers.

The right-angled silicon wafer is prone to stress concentration in use, causing fragmentation of the silicon wafer 1, which affects the quality of the solar cell 51 and the photovoltaic module. Therefore, the silicon wafer 1 with chamfers is generally used to reduce the fragmentation possibility of the silicon wafer 1. The chamfer is in a circular arc shape. Since the cross section of the silicon ingot 9 is circular, the required chamfered arc can be coincide with a segment of the circumference of the cross section of the silicon ingot 9 during the cutting, so that the silicon wafer 1 with chamfers can be directly obtained after the cutting, and a step of chamfering the silicon wafer 1 can be omitted, which simplifies a manufacturing process of the photovoltaic module and is more in line with an actual use requirement. Therefore, four diagonal corners of the silicon wafer 1 can be determined by selecting four arc segments on the circumference of the silicon ingot 9, so as to determine a position of the full silicon wafer 1. Next, the silicon ingot 9 is cut. That is, the silicon ingot 9 is cut along a length direction (the longitudinal direction) of the silicon ingot 9 to obtain the rectangular body with chamfers. Next, the obtained rectangular body is cut along a direction perpendicular to the length direction of the silicon ingot 9, i.e., along a radial direction of the silicon ingot 9, to obtain the silicon wafer 1 with chamfers. Busbars 2 and finger electrodes are arranged on the silicon wafer 1, and then processing such as soldering are performed to obtain the solar cell 51 required for the photovoltaic module. Compared with the solution in which the silicon ingot 9 is cut along an inscribed quadrilateral of the cross section of the silicon ingot 9, the silicon wafer 1 obtained according to the cutting method provided in embodiments of the present disclosure has a larger area, and thus has a larger light-receiving area and has higher utilization of the silicon ingot 9. As a result, efficiency of the solar cell 51 and the photovoltaic module is improved, and the cost is reduced.

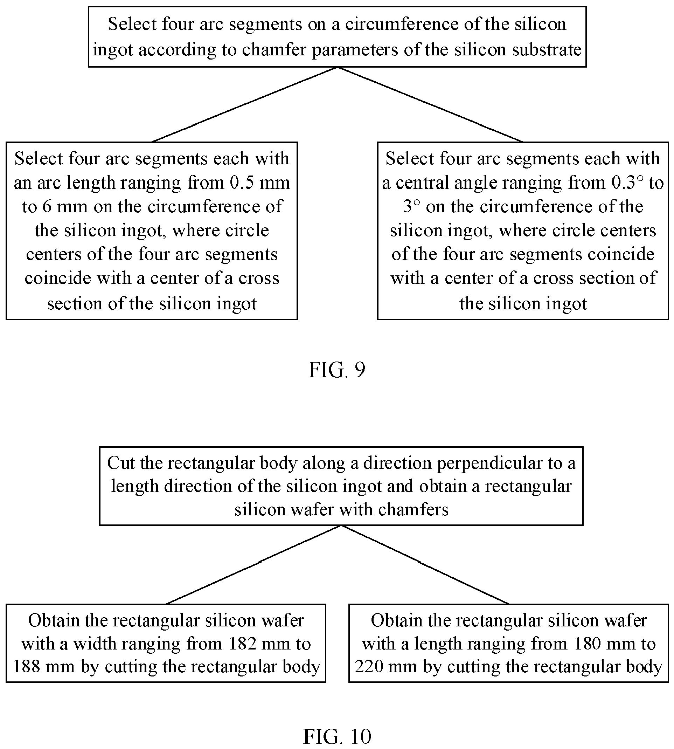

As shown in FIG. 9, some embodiments, step S1 further includes step S11.

In step S11, four arc segments each with an arc length ranging from 0.5 mm to 6 mm are selected on the circumference of the silicon ingot 9, and circle centers of the arc segments coincide with a center of a cross section of the silicon ingot 9.

The right-angled silicon wafer 1 (the silicon wafer 1 without chamfers) has low utilization for the silicon ingot 9, is prone to stress concentration at a right-angle position, and is easily touched during subsequent processing and use, leading to fragmentation of the silicon wafer 1 and missing of a right-angle portion, which affects an area and quality of the solar cell 51 and also easily leads to failure of the solar cell 51, that is, increasing the cost of the photovoltaic module.

When the silicon wafer 1 has larger chamfers, there is a greater impact on the area of the silicon wafer1, resulting in a decrease in the area of the silicon wafer 1, thereby affecting the efficiency of the solar cell 51 and the photovoltaic module. In the manner provided in embodiments of the present disclosure, smaller chamfers can be obtained, which increases the area of the silicon wafer 1 while reducing the fragmentation possibility of the silicon wafer 1, thereby increasing the light-receiving area of the solar cell 51. The circle centers of the arc segments coincide with the center of the cross section of the silicon ingot, so that segments of the circumference of the silicon ingot 9 can be directly used as the chamfer of the silicon wafer 1 after the cutting, and secondary machining is no longer required. In this way, a manufacturing process of the solar cell 51 and the photovoltaic module is simplified, which is more in line with an actual manufacturing requirement.

As shown in FIG. 9, in some embodiments, step S1 further includes step S12.

In S12: four arc segments with central angles ranging from 0.3° to 3° are selected on the circumference of the silicon ingot 9, and circle centers of the arc segments coincide with a center of a cross section of the silicon ingot 9.

In this way, a step of performing secondary machining on the silicon wafer 1 to obtain a chamfer may be omitted, which is more in line with an actual manufacturing requirement. When the arc segments are smaller, an influence of the chamfer on an actual area of the silicon wafer 1 can be reduced, which increases an area of the silicon wafer 1, thereby improving the efficiency of the solar cell 51 and the photovoltaic module.

Compared with the solution in which the silicon ingot 9 is cut along an inscribed square of the circumference of the silicon ingot 9, the silicon wafer 1 cut by the method provided in embodiments of the present disclosure has a larger area and a higher utilization for the silicon ingot 9, thereby reducing the cost.

As shown in FIG. 10, in some embodiments, step S3 includes one or more of the following steps.

In S31, the rectangular silicon wafer 1 with a width ranging from 182 mm to 188 mm is obtained by cutting.

In S32, the rectangular silicon wafer 1 with a length ranging from 180 mm to 220 mm is obtained by cutting.

Compared with the square silicon wafer 1, the rectangular silicon wafer 1 has a larger area, the light-receiving area of the silicon wafer 1 is increased, and utilization of the silicon ingot 9 is higher, thereby reducing the cost.

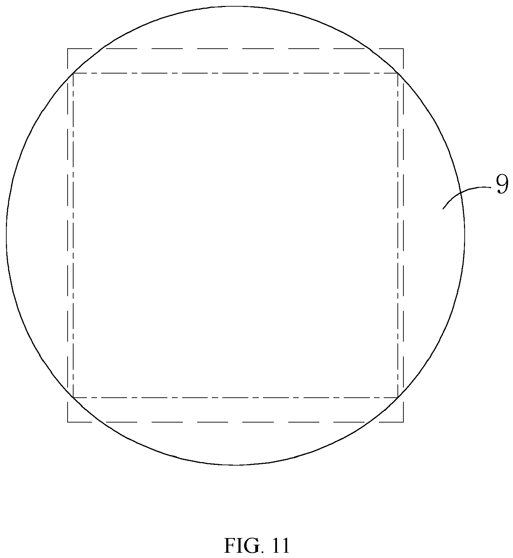

As shown in FIG. 11, dotted lines in the figure represent a range of the rectangular silicon wafer 1 obtained by the method for manufacturing the silicon wafer 1 provided in embodiments of the present disclosure, and dot-and-dash lines in the figure represent a range of a conventional square silicon wafer 1. According to common knowledge, when an inscribed quadrilateral of a circle is a square, an area of the inscribed quadrilateral is maximum. As shown in FIG. 11, with the method for manufacturing the silicon wafer 1 provided in embodiments of the present disclosure, the square silicon wafer 1 is entirely within the range of the silicon wafer 1 obtained by the method provided in embodiments of the present disclosure. A length and a width of the silicon wafer 1 obtained according to the method provided in embodiments of the present disclosure are greater than those of the conventional square silicon wafer 1. Therefore, the method for manufacturing the silicon wafer 1 provided in embodiments of the present disclosure has higher utilization of the silicon ingot 9 than the conventional method. Therefore, the area of the solar cell 51 is increased, efficiency of the solar cell 51 and the photovoltaic module is improved, and the cost is reduced.

As shown in FIG. 8, a width W of the silicon wafer 1 may be 182 mm, 183 mm, 184 mm, 185 mm, 186 mm, 187 mm, 188 mm, or the like. A length L of the silicon wafer 1 may be 180 mm, 184 mm, 188 mm, 192 mm, 196 mm, 200 mm, 204 mm, 208 mm, 212 mm, 216 mm, 220 mm, or the like.

The silicon wafer 1 may be in a shape of a rectangle. This design is conducive to transportation after the solar cells are assembled and improves space utilization. Moreover, compared with the square silicon wafer 1, the rectangular silicon wafer 1 has a larger area, which improves efficiency of the solar cell 51 and the photovoltaic module, and improves utilization of the silicon ingot 9, reduces the cost. Dimensions of the solar cell 51 may be the same as those of the silicon wafer 1.

For example, the silicon wafer is manufactured from a silicon ingot 9 with a diameter of 252. The width/length of the manufactured square silicon wafer 1 is generally 182 mm. The rectangular silicon wafer 1 manufactured according to the method of the present disclosure may be 182 mm in width and 190 mm in length. A cross-sectional area of the circular silicon ingot 9 is about 49875.925 mm². The silicon ingot 9 is cut and machined to obtain a square silicon wafer 1 and a rectangular silicon wafer 1. The square silicon wafer 1 has an area of about 33094.7715 mm², and the rectangular silicon wafer 1 has an area of about 34454.6839 mm². For the square silicon wafer 1, the utilization of the silicon ingot 9 is 33094.7715/49875.925, which is about 66.3%. For the rectangular silicon wafer 1, the utilization of the silicon ingot 9 is 34454.6839/49875.925, which is about 69.1%. In view of this, it may be concluded that the utilization of the silicon ingot 9 can be significantly improved by the method for manufacturing the silicon wafer 1 provided in embodiments of the present disclosure, thereby reducing the cost.

Moreover, the photovoltaic module composed of the silicon substrates 1 manufactured according to the method provided in embodiments of the present disclosure is more suitable for dimensions of the container, which can improve efficiency of the photovoltaic module and improve efficiency of transportation.

As shown in FIG. 6, in some embodiments, the method for manufacturing the silicon substrate 1 may include step S4.

In step S4: the rectangular silicon substrate 1 is divided into two symmetrical half-cut cells by cutting the rectangular silicon substrate 1 along a straight line parallel to a width direction of the rectangular silicon substrate 1.

Generally, the solar cell 51 used in the photovoltaic module has a half-cut-cell structure. Compared with a full-cell structure, the photovoltaic module adopting the half-cut-cell structure has higher efficiency. Therefore, the silicon wafer 1 is cut in the method, to obtain the half-cut-cell structure. The step of cutting the solar cell into half-cut cells may be performed after the silicon wafer 1 is machined into the solar cell 51.

In some embodiments, the step of cutting the full-cell silicon wafer into half-cut-cell silicon wafer may be performed during the manufacturing of the silicon substrate 1, or performed during the manufacturing of the solar cell 51, or performed in the manufacturing of the photovoltaic module.

In some embodiments, in the method for manufacturing the silicon substrate 1, the silicon ingot 9 may be directly cut, the silicon ingot 9 is cut into a rectangular body or a rectangular body with chamfers, and a cross-sectional area of the rectangular body after the cutting is larger than that of the required silicon substrate 1. The rectangular body is sliced, and the silicon wafer 1 is machined according to chamfer parameters of the required solar cell 51 after the slicing, to obtain the silicon wafer 1 having the corresponding chamfers. The break and crack are prone to occur on the right-angled silicon substrate during the use, which may affect the quality of the solar cell 51 and the photovoltaic module. Therefore, the silicon substrate 1 with chamfers is generally used to manufacture the solar cell 51 and the photovoltaic module.

In some embodiments, the diameter of the silicon ingot 9 may be increased, and a right-angled rectangular silicon wafer 1 (without a chamfering structure) may be obtained by directly cutting the silicon ingot 9. The rectangle of the silicon wafer may be an inscribed quadrilateral of the circular cross section of the silicon ingot 9, or a rectangle with an area smaller than that of the inscribed quadrilateral of the circular cross section of the silicon ingot 9. After the cutting, the right-angled rectangular silicon wafer 1 may be directly used, or the right-angled rectangular silicon wafer 1 is subsequently processed to have chamfers.

The present disclosure relates to a solar cell 51, a photovoltaic module, and a method for manufacturing a silicon substrate 1. The solar cell 51 includes a silicon substrate 1 in a rectangular shape. The silicon substrate 1 is provided with 13 to 20 busbars 2. The busbars 2 are sequentially arranged along a width direction of the solar cell 51 at an equal distance between adjacent busbars. The distance between adjacent busbars 2 is *a* mm. An distance between the outermost busbar 2 and an edge of the silicon substrate 1 adjacent to the outermost busbar 2 along the width direction of the solar cell 51 is *b* mm, where *a*-1≤2*b.* With this design, a transport distance of a current at the edge of the silicon substrate 1 is reduced, which improves efficiency of the solar cell 51 and is more in line with an actual use requirement.

The above are merely some embodiments of the present disclosure, and are not intended to limit the present disclosure. For those skilled in the art, the present disclosure may be subject to various modifications and changes. Any modification, equivalent replacement, improvement and the like within the spirit and principle of the present disclosure all fall within the protection scope of the present disclosure.

## Claims

1. A solar cell (51), comprising:
a silicon substrate (1) in a rectangular shape; and
13 to 20 busbars (2) arranged on the silicon substrate (1),
wherein the busbars (2) extend along a length direction of the solar cell (51) and are sequentially arranged along a width direction of the solar cell (51) at an equal spacing of *a* mm,
wherein the silicon substrate (1) comprises a first edge and a second edge opposite to the first edge in the width direction of the solar cell (51), and a between the first edge of the silicon substrate (1) and an outermost busbar (2) of the busbars (2) adjacent to the first edge is *b* mm, where *a*-1≤2*b*≤*a*+1*.*

2. The solar cell according to claim 1, wherein the spacing *a* between adjacent busbars (2) is twice of the distance b, preferably the distance *b* satisfies: 5 mm≤*b*≤10 mm, and the spacing *a* between adjacent busbars (2) satisfies: 10 mm≤*a*≤20 mm.

3. The solar cell according to claim 1, wherein a width of the solar cell (51) ranges from 182 mm to 210 mm, and a length of the solar cell (51) ranges from 180 mm to 220 mm.

4. The solar cell according to claim 1, wherein the solar cell (51) comprises two half-cut solar cells, the two half-cut solar cells are symmetrical about a center line of the solar cell (51) extending along the width direction of the solar cell (51).

5. The solar cell according to claim 1, wherein the number of the busbars (2) ranges from 13 to 16.

6. The solar cell according to claim 1, wherein the silicon substrate (1) has a chamfered arc, and the chamfered arc has an arc length ranging from 0.5 mm to 6 mm or a central angle ranging from 0.3° to 3°.

7. A photovoltaic module, comprising: a first cover plate (3), a first sealant (4), a solar cell layer (5), a second sealant (6), and a second cover plate (7) that are sequentially arranged along a thickness direction,
wherein the solar cell layer (5) comprises a solar cell array having a plurality of solar cells (51), and the plurality of solar cells (51) is configured to be processed to half-cut solar cells, wherein a solar cell of the plurality of solar cells (51) comprises:
a silicon substrate (1) in a rectangular shape; and
13 to 20 busbars (2) arranged on the silicon substrate (1),
wherein the busbars (2) extend along a length direction of the solar cell (51) and are sequentially arranged along a width direction of the solar cell (51) at an equal spacing of *a* mm,
wherein the silicon substrate (1) comprises a first edge and a second edge opposite to the first edge in the width direction of the solar cell (51), and a distance between the first edge of the silicon substrate (1) and an outermost busbar (2) of the busbars (2) adjacent to the first edge is *b* mm, where *a*-1≤2*b*≤*a*+1*.*

8. The photovoltaic module according to claim 7, wherein a width of the photovoltaic module ranges from 1130 mm to 1138 mm, and a length of the photovoltaic module ranges from 2380 mm to 2384 mm.

9. The photovoltaic module according to claim 8, wherein 4 to 6 solar cells (51) of the plurality of solar cells (51) are arranged along a width direction of the photovoltaic module, and 8 to 14 solar cells (51) of the plurality of solar cells (51) are arranged along a length direction of the photovoltaic module.

10. A method for manufacturing the silicon substrate of the solar cell according to claim 1, comprising:
providing a cylinder silicon ingot (9) with a cross-section diameter ranging from 252 mm to 277 mm;
selecting four arc segments on a circumference of the silicon ingot (9) according to chamfer parameters of the silicon substrate (1);
cutting the silicon ingot (9) along connection lines between adjacent arc segments to obtain a rectangular body having a rectangular cross-section shape with chamfers; and
cutting the rectangular body along a direction perpendicular to a length direction of the silicon ingot (9) and obtaining a rectangular silicon wafer with chamfers.

11. The method according to claim 10, wherein the selecting four arc segments on a circumference of the silicon ingot (9) according to chamfer parameters of the silicon substrate (1) comprises:
selecting four arc segments each with an arc length ranging from 0.5 mm to 6 mm on the circumference of the silicon ingot (9), wherein circle centers of the four arc segments coincide with a center of a cross section of the silicon ingot (9).

12. The method according to claim 10, wherein the selecting four arc segments on a circumference of the silicon ingot (9) according to chamfer parameters of the silicon substrate (1) comprises:
selecting four arc segments each with a central angle ranging from 0.3° to 3° on the circumference of the silicon ingot (9), wherein circle centers of the four arc segments coincide with a center of a cross section of the silicon ingot (9).

13. The method according to claim 10, wherein the cutting the rectangular body with chamfers along a direction perpendicular to a length direction of the silicon ingot (9) and obtaining a rectangular silicon wafer with chamfers comprises:
obtaining the rectangular silicon wafer with a width ranging from 182 mm to 188 mm by cutting the rectangular body.

14. The method according to claim 10, wherein the cutting the rectangular body along a direction perpendicular to a length direction of the silicon ingot (9) and obtaining a rectangular silicon wafer with chamfers comprises:
obtaining the rectangular silicon wafer with a length ranging from 180 mm to 220 mm by cutting the rectangular body.

15. The method according to claim 10, wherein, after obtaining the rectangular silicon wafer with chamfers, the method further comprises:
cutting, along a straight line parallel to a width direction of the rectangular silicon wafer, the rectangular silicon wafer into two symmetrical half-cut wafers.
